# EUROPEAN PATENT APPLICATION

(11) **EP 4 672 889 A2**
(43) Date of publication of application: **31.12.2025**
(21) Application number: 25180861.4
(22) Date of filing: 04.06.2025
(51) Int. Cl.: H05K 7/20

(54) **COIL BANKS FOR COOLANT DISTRIBUTION UNITS**

(30) Priority: 05.06.2024 US 202463656379 P
(71) Applicant: Hoffman Enclosures Inc., Anoka, MN 55303 (US)
(72) Inventor: Kundem, Jeshwanth Durga Sagar, Minneapolis (US)
(74) Representative: Barker Brettell LLP

(57) **Abstract**

A cooling distribution unit (100) includes a housing (106) defining a width between a first lateral side wall and a second lateral side wall, and a coil bank (120) disposed within the housing. The coil bank includes a first heat exchanger (122) defining a first width (W1) and a second heat exchanger (124) defining a second width (W2), where the second heat exchanger is arranged fluidically in parallel with the first heat exchanger so that fluid flows to the first heat exchanger, the second heat exchanger, or both the first heat exchanger and the second heat exchanger. A sum of the first width of the first heat exchanger and the second width of the second heat exchanger is greater than the width of the housing. The cooling distribution unit further includes a fan assembly (112) to direct airflow through the coil bank to cool a fluid passing through the first heat exchanger and the second heat exchanger.

## Description

### CROSS REFERENCE TO RELATED APPLICATIONS

This application claims priority to U.S. Application No. 63/656,379, titled COIL BANKS FOR COOLANT DISTRIBUTION UNITS, filed June 5, 2024, which is hereby incorporated by reference in its entirety.

### BACKGROUND

Cooling systems can be provided for electrical components in data centers. In some cases, equipment in a data center can be cooled with various approaches, including with liquid-based cooling systems, air-based cooling systems, or combinations thereof. Electrical equipment within a data center can be housed in racks and can include a coil bank for cooling components of electrical equipment.

### SUMMARY

According to one aspect of the present disclosure, a cooling distribution unit can include a housing defining a width between a first lateral side wall and a second lateral side wall. A coil bank can be disposed within the housing. The coil bank can include a first heat exchanger defining a first width and a second heat exchanger defining a second width. The second heat exchanger can be arranged fluidically in parallel with the first heat exchanger so that fluid flows to the first heat exchanger, the second heat exchanger, or both the first heat exchanger and the second heat exchanger. A sum of the first width of the first heat exchanger and the second width of the second heat exchanger can be greater than the width of the housing. A fan assembly can direct airflow through the coil bank to cool a fluid passing through the first heat exchanger and the second heat exchanger.

In some examples, the first width of the first heat exchanger can be greater than 60% of the width of the housing.

In some examples, the second width of the second heat exchanger can be greater than 60% of the width of the housing.

In some examples, the cooling distribution unit can further include a baffle extending between the first heat exchanger and the second heat exchanger to direct air flow from the fan assembly through the first heat exchanger and the second heat exchanger.

In some examples, the first heat exchanger and the second heat exchanger can be offset to form a first gap between the first heat exchanger and the second lateral side wall and a second gap between the second heat exchanger and the first lateral side wall.

In some examples, the first gap can permit airflow from the fan assembly to bypass the first heat exchanger and flow to the second heat exchanger.

In some examples, the first heat exchanger and the second heat exchanger can at least partially overlap in a direction parallel the direction of air flow from the fan assembly.

According to another aspect of the present disclosure, a method of operating a cooling distribution unit having redundant heat exchangers can include selectively directing fluid flow to a first heat exchanger, a second heat exchanger, or both the first heat exchanger and the second heat exchanger, the first heat exchanger and the second heat exchanger arranged in a fluidically parallel arrangement. The method can include monitoring the first heat exchanger and the second heat exchanger for fluid leakage using a leak detection system. The method can include detecting fluid leakage from the first heat exchanger. The method can include controlling a flow control valve to restrict fluid flow to the first heat exchanger in response to detecting the fluid leakage. The method can include adjusting a fan speed of a fan assembly to increase airflow over the second heat exchanger to compensate for reduced cooling capacity from the first heat exchanger.

In some examples, the leak detection system can include leak detection cables positioned near the first heat exchanger and the second heat exchanger.

In some examples, controlling the flow control valve can include closing a fluid access port to the first heat exchanger and directing a greater flow rate of fluid to the second heat exchanger via increasing an operational speed of a pump.

In some examples, the flow control valve can be a three-way valve configured to selectively provide fluid flow to the first heat exchanger, the second heat exchanger, or both the first heat exchanger and the second heat exchanger.

In some examples, the first heat exchanger can be a microchannel heat exchanger.

In some examples, the first heat exchanger and the second heat exchanger can be arranged within a housing defining a width between a first lateral side wall and a second lateral side wall, and the first heat exchanger can define a first width that is greater than 60% of the width of the housing.

In some examples, the second heat exchanger can define a second width, and a sum of the first width of the first heat exchanger and the second width of the second heat exchanger can be greater than the width of the housing.

In some examples, the method can further include directing air flow from the fan assembly through the first heat exchanger and the second heat exchanger via a baffle extending between the first heat exchanger and the second heat exchanger.

According to yet another aspect of the present disclosure, a cooling distribution unit can include a housing and a coil bank disposed within the housing. The coil bank can include a first heat exchanger and a second heat exchanger arranged fluidically in parallel with the first heat exchanger. A flow control valve can be positioned upstream of the coil bank and configured to selectively direct fluid flow to the first heat exchanger, the second heat exchanger, or both the first heat exchanger and the second heat exchanger. A leak detection system can detect fluid leakage from the first heat exchanger or the second heat exchanger. A controller can control the flow control valve based on signals from the leak detection system.

In some examples, the flow control valve can be a three-way valve configured to selectively provide fluid flow to the first heat exchanger, the second heat exchanger, or both the first heat exchanger and the second heat exchanger.

In some examples, the cooling distribution unit can further include a fan assembly, and the controller can increase an operational speed of the fan assembly when the leak detection system detects fluid leakage from the first heat exchanger or the second heat exchanger.

In some examples, the controller can increase fan speed to compensate for reduced cooling capacity from a non-functioning heat exchanger.

In some examples, the controller can close a fluid access port from the flow control valve to a non-functioning heat exchanger and direct a greater flow rate of fluid to a functioning heat exchanger to maintain overall system cooling capacity when the leak detection system detects fluid leakage.

Features which are described in the context of separate aspects and/or embodiments of the invention may be used together and/or be interchangeable wherever possible. Similarly, where features are, for brevity, described in the context of a single embodiment, those features may also be provided separately or in any suitable sub-combination. Features described in connection with the cooling distribution unit may have corresponding features definable and/or combinable with respect to a method or vice versa, and these embodiments are specifically envisaged.

### BRIEF DESCRIPTION OF THE DRAWINGS

The accompanying drawings, which are incorporated in and form a part of this specification, help illustrate various features of non-limiting examples of the disclosure and are not intended to limit the scope of the disclosure or exclude alternative implementations.
FIG. 1 is an axonometric view of a coolant distribution unit (CDU) according to an example of the disclosure.
FIG. 2 is a partial axonometric view of the CDU of FIG. 1, with panels removed showing internal components.
FIG. 3 is a top plan view of the CDU of FIG. 2.
FIG. 4 is a partial axonometric view showing details of a coil bank of the CDU of FIG. 2.
FIG. 5 is a diagrammatic view of a CDU according to an example of the disclosure.
FIG. 6 is a diagrammatic view of a CDU according to an example of the disclosure.
FIG. 7 is a diagrammatic view of a CDU according to an example of the disclosure.
FIG. 8 is a diagrammatic view of a CDU illustrating an example arrangement of a coil bank and a fan assembly according to an example of the disclosure.
FIG. 9 is a diagrammatic view of a CDU illustrating another example arrangement of a coil bank and a fan assembly according to an example of the disclosure.
FIG. 10 is a diagrammatic view of a CDU illustrating another example arrangement of a coil bank and a fan assembly according to an example of the disclosure.
FIG. 11 is a diagrammatic view of a CDU illustrating an example arrangement of a coil bank and a fan assembly according to an example of the disclosure.
FIG. 12 is a diagrammatic view of a CDU illustrating an example of a redundant heat exchanger arrangement according to an example of the disclosure.
FIG. 13 is a flowchart illustrating a method of operating the redundant heat exchanger arrangement of FIG. 12 according to an example of the disclosure.

### DETAILED DESCRIPTION

Before any embodiments of the present disclosure are explained in detail, it is to be understood that the present disclosure is not limited in its application to the details of construction and the arrangement of components set forth in the following description or illustrated in the following drawings. The present disclosure is capable of other embodiments and of being practiced or of being carried out in various ways. Also, it is to be understood that the phraseology and terminology used herein is for the purpose of description and should not be regarded as limiting. The use of "including," "comprising," or "having" and variations thereof herein is meant to encompass the items listed thereafter and equivalents thereof as well as additional items. Unless specified or limited otherwise, the terms "mounted," "connected," "supported," and "coupled" and variations thereof are used broadly and encompass both direct and indirect mountings, connections, supports, and couplings. Further, "connected" and "coupled" are not restricted to physical or mechanical connections or couplings.

The following discussion is presented to enable a person skilled in the art to make and use embodiments of the present disclosure. Various modifications to the illustrated embodiments will be readily apparent to those skilled in the art, and the generic principles herein can be applied to other embodiments and applications without departing from embodiments of the present disclosure. Thus, embodiments of the present disclosure are not intended to be limited to embodiments shown but are to be accorded the widest scope consistent with the principles and features disclosed herein. The following detailed description is to be read with reference to the figures, in which like elements in different figures have like reference numerals. The figures, which are not necessarily to scale, depict selected embodiments and are not intended to limit the scope of embodiments of the present disclosure. Skilled artisans will recognize the examples provided herein have many useful alternatives and fall within the scope of embodiments of the present disclosure.

Cooling systems can be provided for a space (e.g., data centers) to cool electrical components within the space. During operation, electrical components, typically housed in racks having a standard rack footprint (e.g., a standard height, width, and depth), generate heat. As that heat may degrade electrical components, damage the systems, or otherwise degrade performance, cooling systems can be provided for data centers to transfer heat away from electrical components on racks of the data center. Cooling systems for data centers can include liquid cooling circuits, with a liquid coolant circulated through the circuit to cool electrical equipment within a data center.

Liquid cooling systems can be provided to cool electrical equipment (e.g., servers, network switches, routers, storage drives, etc.) by circulating a liquid coolant (e.g., water, a water/glycol mixture, ethanol, a dielectric fluid, etc.) to the equipment. The type of liquid coolant can be determined based on factors such as thermal conductivity, electrical conductivity, viscosity, freezing point, compatibility with system components, and types of liquid cooling systems. The liquid coolant can absorb a heat from the electrical equipment (e.g., via a direct-to-chip cooling, immersion cooling, or a combination thereof), and can flow out of the electrical equipment, transferring a heat from the electrical equipment. CDUs can be provided along a liquid cooling circuit to pump and process a fluid of the liquid cooling circuit. A CDU can include one or more pumping units to pump a liquid coolant through a cooling circuit, and a heat exchanger to transfer a heat from the liquid coolant (e.g., to cool the liquid coolant) before the liquid coolant is recirculated to the electrical equipment. In some conventional systems, a CDU can comprise an in-row CDU, and can be housed in a dedicated rack within a data center, the rack including the pumping components and heat exchangers for transferring a heat from the liquid coolant (e.g., through a liquid-to-air (LTA) heat exchanger, a liquid-to-liquid (LTL) heat exchanger, etc.).

In some cases, it can be advantageous to provide liquid-cooled racks within a data center with a self-contained liquid cooling circuit (e.g., a rack with liquid-cooled elements that do not require integration with a liquid cooling circuit external to the rack). For example, integrating a rack with extant liquid cooling circuits of a data center can impose a labor cost, and can increase a risk of leakage of the system, as well as increasing system complexity. According to some examples of the disclosure, then, in-rack CDUs can be provided for a rack of electrical equipment. An in-rack CDU can occupy a space within a rack containing electrical equipment (e.g., servers) and can provide pumping, filtration, and heat exchange capacity for the electrical equipment of the rack. In-rack CDUs, according to the present disclosure can be compact (e.g., can occupy a height of less than 20U within a rack), and can allow a rack to include a maximum amount of electrical equipment. In some examples, in-rack CDUs can include modular, redundant components (e.g., pumps, fans, controllers, heat exchangers, etc.) that enhance maintenance process and replacement of the components without disrupting operation of other components of the in-rack CDUs or the rack.

Some examples of the present disclosure can provide an in-rack LTA CDU. The in-rack LTA CDU can include a liquid inlet which can be downstream of a return manifold, and a liquid outlet, which can be upstream of a supply manifold. One or more pumps and one or more heat exchangers can be positioned fluidly between the liquid inlet and the liquid outlet. In some examples, the pumps can be variable speed pumps that adjust flow rates of the liquid coolant, for example, based on cooling demands of the electrical equipment. The one or more heat exchangers can be LTA heat exchangers and can transfer a heat from a liquid flowing through the one or more heat exchangers to a secondary fluid (e.g., air). In some cases, air flow can be generated across the one or more heat exchangers (e.g., via fans, etc.) to increase a cooling capacity and cooling efficiency of the CDU. For example, in some examples of the present disclosure, an in-rack CDU can include one or more fans positioned and configured to induce an airflow across the one or more heat exchangers to transfer a heat from the liquid flowing through the one or more heat exchangers.

Conventional CDUs can include a heat exchanger (e.g., coils, heat exchange coils, etc.) with a surface area over which air can flow, and the amount of surface area can have a positive relationship with a heat transfer of the heat exchanger. For example, the heat transfer coefficient and overall thermal performance can be proportional to an available surface area that the air can flow across. Larger surface areas can permit more efficient heat dissipation in a given amount of space vs. comparatively smaller surface areas. In some cases, heat exchangers can be canted, tilted, or otherwise angled to increase a surface area for heat transfer within a given space (e.g., within an in-rack CDU or an in-row CDU).

As should be appreciated, modern computing equipment is being used to perform a greater number of operations with a higher density and can require greater heating capacity relative to traditional equipment. For example, high-performance computing applications, artificial intelligence and machine learning workloads, simulations, or dense virtualization environments can generate a larger amount of heat per rack than the traditional equipment. Therefore, there is a need to increase a cooling capacity of CDUs given space constraints (e.g., increase a cooling capacity of an in-rack CDU without increasing a size of the CDU, rack, etc.). Examples of the disclosed technology can address these or other issues. In particular, some examples of the disclosed technology can provide an arrangement of a coil bank for a CDU with a plurality of heat exchangers.

Some examples of the present disclosure can provide high-density in-rack CDUs, with greater cooling capacity than conventional CDUs. In particular, CDUs, according to the present disclosure can include coil banks (e.g., banks of LTA heat exchangers) arranged within a CDU and configured to maximize a heat exchange capacity of the CDU. In some cases, individual heat exchangers of a coil bank can be arranged in a staggered configuration. For example, two heat exchangers (e.g., coils) can be placed within a CDU, each having a surface area either perpendicular to, or at an oblique angle relative to an air flow through the CDU. In some cases, a combined width of the two heat exchangers can be greater than a width of a single heat exchanger spanning lateral sides (e.g., across) of a CDU. The two heat exchangers can be offset relative to each other (e.g., in a direction parallel to an air flow). In some examples, a baffle can be provided to connect lateral ends of the heat exchangers and close an air path between the heat exchangers (e.g., to decrease a likelihood of air flowing around instead of through the heat exchanger coils). Accordingly, the air path for each heat exchanger can be separated, and heat transfer between multiple air paths can be reduced or prevented. Fans and baffles of a CDU can be configured to distribute air flow evenly across heat exchangers of a coil bank of the CDU, as described below.

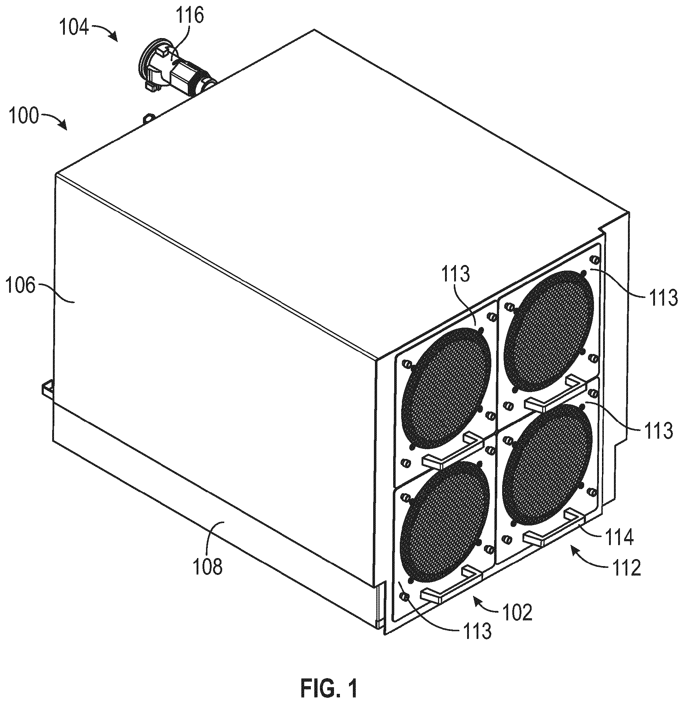

FIGS. 1-4 illustrate aspects of a cooling distribution unit (CDU) 100 according to some examples. The CDU 100 shown is an in-rack CDU sized and configured to be housed within a rack of electrical equipment. However, coil banks, as described herein can be advantageously used in other cooling appliances, including, for example, in in-row CDUs, and the description of coil banks of the in-rack CDU 100 can be applicable in the context of other appliances. As shown, the CDU 100 includes a front (e.g., first) end 102 that may face a first aisle within a data center and a rear (second) end 104 that may face a second aisle, opposite the first aisle. The CDU 100 includes a housing 106 with a plurality of walls (e.g., a top wall and side walls) and a sled 108 that can collectively define an internal volume of the CDU 100. The housing 106 may shield internal components of the CDU 100 from view. The housing 106 can further function as a baffle at least partially defining an air-flow channel, and at least partially preventing a leakage of air from the CDU 100 through the lateral sides and top of the CDU 100. By forming a semi-enclosed space, the housing 106 can enhance control of operating conditions (e.g., temperature, humidity, etc.) or guide air flow across the CDU 100. In the illustrated example, the CDU 100 defines a height of 11 U, (i.e., 11 rack units, a rack unit being 1.75 inches). In some cases, the CDU 100 can be defined by a height of 8 rack units (U), although smaller or larger height of a CDU is possible (e.g., based on a size of a rack). For example, a CDU can comprise an in-row CDU and can be in a dedicated rack for cooling operations in a data center.

As noted above, CDUs can include air flow elements to induce an air flow across an LTA heat exchanger. As further shown in FIG. 1, a fan assembly 112 including a plurality of fans 113 can be provided at the front side 102 of the CDU 100 to induce air flow across one or more LTA heat exchangers housed within the CDU 100 (e.g., a first heat exchanger 122 and a second heat exchanger 124). In the illustrated example, the fan assembly 112 includes four fans 113 arranged in two columns and two rows. In other examples, more or fewer columns of fans can be provided for a CDU including one column, three columns, four columns, etc. In some cases, the fan assemblies can include more or fewer rows of fans, which can correlate to a height of the CDU 100.

In some cases, each fan 113 can be separately maintainable (e.g., removable or installable via a handle 114). For example, in the illustrated example, the fans 113 are configured for tool-less removal from and insertion into the CDU 100. For example, an operator can engage thumb screws of the respective fans 113 to tighten or loosen the fan 113 relative to the CDU 100, and can further engage a handle 114 of the respective fan 113 to pull the fan 113 from or push the fan 113 into a corresponding slot of the CDU 100. In some cases, the fans 113 include blind mate electrical connections to automatically connect with electrical and control systems of the CDU 100 when inserted into a slot of the CDU 100. Further, the fans 113 can be inserted and removed without producing a downtime of the CDU 100 (e.g., the fans can be "hot-swappable"). In some cases, the fans 113 can include fan motors, one or more sensors (e.g., temperature sensors, humidity sensors, air-flow sensors, etc.), and a fan controller, and can be controllable to produce a set amount of air flow across LTA heat exchangers of the CDU 100 for a desired heat transfer rate. For example, the fans 113 can be operated based on PID controllers that can increase or decrease speeds of the fans 113 to achieve a set point of an operating parameter (e.g., a flow rate, a temperature of a liquid coolant, a temperature differential of an air flowing through the CDU, etc.). In some examples, control algorithms of the PID controllers can incorporate adaptive turning parameters that adjust based on operating conditions to maintain optimal performance across varying load conditions or operating conditions of upstream components of the fan assembly 112.

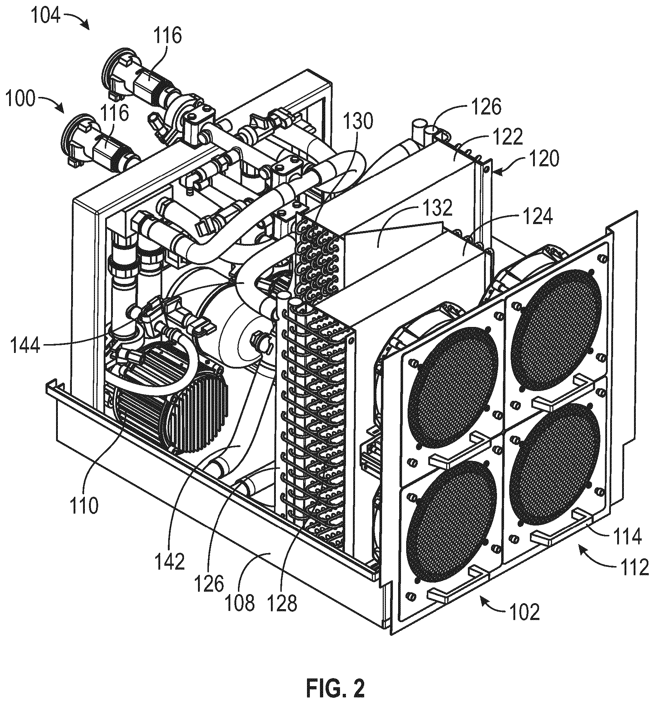

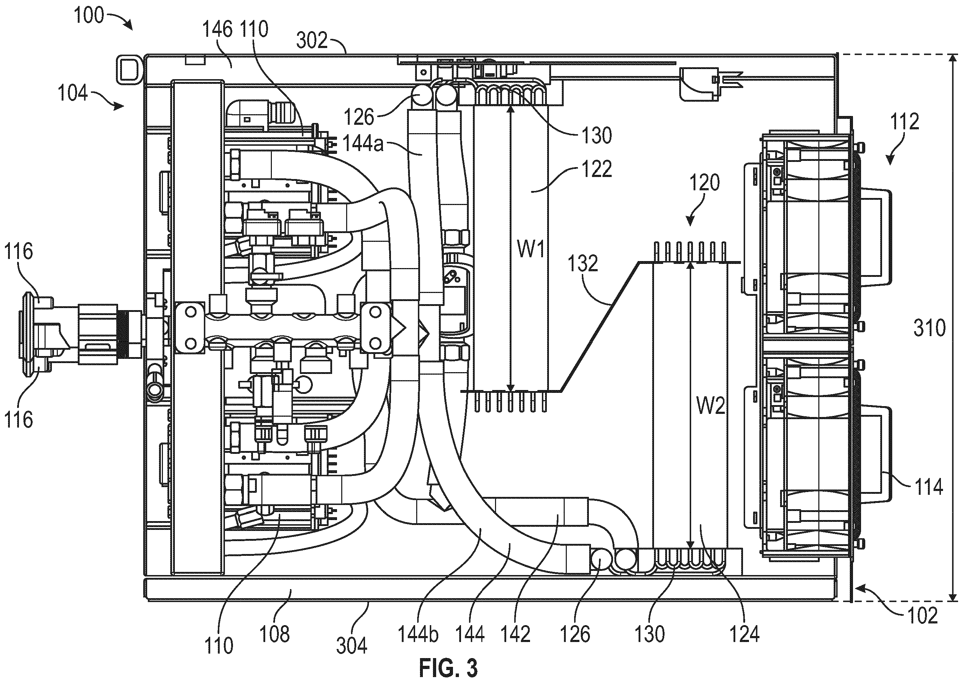

A CDU can include plumbing elements, and control elements to control flow rates of a liquid coolant (e.g., water, a water-glycol combination, a refrigerant, ethanol, a dielectric fluid, etc.) and an air through the CDU. For example. as illustrated in FIG. 2, the CDU 100 may include one or more pumps 110 (e.g., two pumps, etc.), a coil bank 120, the fan assembly 112, and a controller 146 (see, e.g., FIG. 3).

The pumps 110 can be positioned on the rear (e.g., second) end 104 and include inlet and outlet conduits (e.g., pipes) that may be connected to a plumbing network of the CDU 100. For example, the CDU 100 can include valves 116 in fluid communication with the conduits to receive fluids from the plumbing network or distribute the fluids back to the plumbing network. The pumps 110 can induce the fluid flow through various pipes and hosing. In some cases, the pumps 110 can include quick disconnect couplers that can be hot swapped (e.g., exchanged while the CDU is in operation) for maintenance (e.g., via an actuating mechanism). In some examples, the pumps 110 can include a centrifugal pump, a positive displacement pump, a rotary pump, a peristaltic pump, an axial-flow pump, a screw pump, etc.

With specific reference to FIG. 3, the controller 146 can be provided for the CDU 100 to implement control systems and methods for the CDU 100. For example, the controller can be configured to control one or more fan speeds of the fans 113 in the fan assembly 112 to achieve a desired heat transfer rate. In some cases, the controller 146 can implement proportional integral derivative (PID) controllers to adjust one or both of fan speed and a flow rate of fluid through the coil bank 120 to achieve a set point for one or more target parameters (e.g., air or fluid temperature, air or fluid temperature differentials, pressure drop, air flow rate, etc.). The controller 146 can be hot-swappable and can be removed from the CDU 100 without causing an interruption in cooling of the electrical equipment. As shown, the controller 146 is accessible from the external side of the CDU 100 at the rear end 104, and removal, installation, and replacement of the controller 146 can be performed without opening or disassembling the CDU 100 (e.g., via a handle). In some cases, if the controller 146 fails or is removed from operation, electronic components (e.g., fans, flow control components, etc.) can operate at default speeds (e.g., the last known speed, or a hardcoded default speed) until the controller 146 is replaced or is operational. In some examples, the controller 146 can be accessible from the external side of the CDU 100 at different ends, such as the front end 102 and along the sides.

The coil bank 120 can receive the heated fluids (e.g., with flow induced by the pumps 110) from electrical equipment to transfer heat from the fluids to a secondary fluid (e.g., air). In the illustrated example, the coil bank 120 performs a liquid-to-air heat exchange. In other examples, coil banks can be provided for CDUs to perform an air-to-liquid heat exchange, a liquid-to-liquid heat exchange, or a chilling of a fluid through a refrigeration cycle. Coil banks of a CDU can include one or more finned tube heat exchangers that can dissipate heat from the fluids in a closed-loop liquid cooling system. In some examples, other types of heat exchangers (e.g., a shell-and-tube, microchannel, or plate heat exchangers) are possible. In some examples, a microchannel heat exchanger can include a plurality of microchannels that provide an increased amount of available surface area for heat transfer. In some examples, microchannel heat exchangers can be provided in a compact space with a reduced weight and a reduced air friction. In one particular example, the first heat exchanger or the second heat exchanger can be microchannel heat exchanger can be an aluminum microchannel heat exchanger.

In particular, the coil bank 120 can include a first heat exchanger 122 and a second heat exchanger 124 for liquid-to-air heat exchange. The first heat exchanger 122 and the second heat exchanger 124 can each include headers 126 (e.g., supply headers and return headers) that facilitate and distribute a fluid flow through the first heat exchanger 122 and the second heat exchanger 124, respectively. For example, the CDU 100 includes a hot supply hose 144 that is in fluid communication with supply headers 126, permitting heated fluids to be received and distributed to the first heat exchanger 122 and the second heat exchanger 124. Further, the CDU 100 includes a cold return hose 142 that is in fluid communication with return headers, permitting cooled fluids to be distributed out of the first heat exchanger 122 and the second heat exchanger 124.

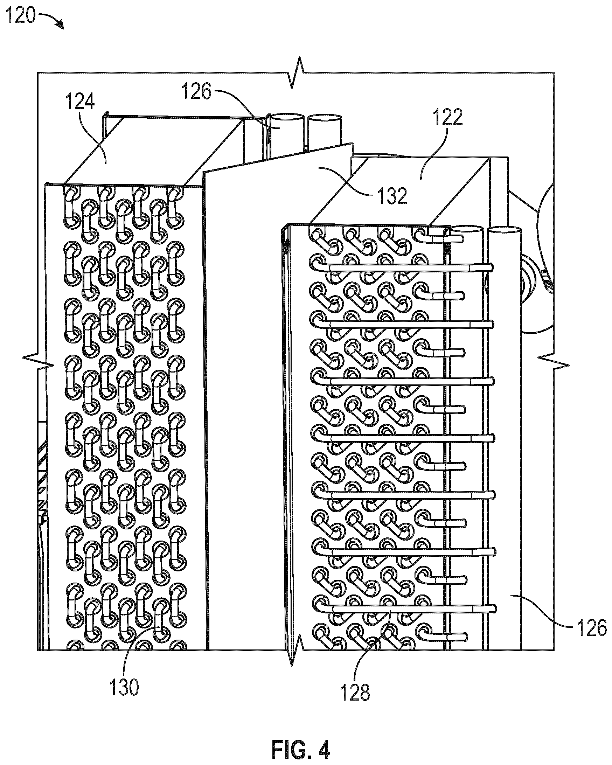

As shown in FIG. 4 in detail, the first heat exchanger 122 and the second heat exchanger 124 can include a plurality of injectors 128 that connect the respective supply headers 126 to a plurality of coils 130 of the first heat exchanger 122 and the second heat exchanger 124. Thus, a stream of heated fluid received from the hot supply hose 144 can be distributed to the plurality of injectors 128 in multiple streams. In some examples, the stream of heated fluid can be evenly distributed between the first heat exchanger 122 and the second heat exchanger 124 or selectively distributed to the first heat exchanger 122 or the second heat exchanger 124 (e.g., depending on a position of a valve, one or more operating parameters of the CDU, etc.). In some examples, the plurality of coils 130 can be looped laterally (e.g., back-and-forth) throughout the first heat exchanger 122 and the second heat exchanger 124. The fluids can be circulated through the plurality of coils 130 (e.g., to be cooled). The streams of cooled fluids can exit the plurality of coils 130 into the return header. Correspondingly, the cooled fluids can be transferred into the cold return hose 142 as a unitary stream. The plurality of injectors 128 can permit distribution of the fluid in an efficient manner or deliver a volume of fluids at a desired flow rate. The plurality of injectors 128 can have a fewer or more individual injectors (e.g., based on a desired volumetric flow rate or heat transfer efficiency). In some cases, a flow capacity of a heat exchanger can correspond to a number of injectors, and heat exchangers with increased flow capacity can be provided for a CDU by increasing a number of injectors that transfer a fluid from a header to a corresponding heat exchanger.

In some cases, condensation can occur on the coil bank 120 during the heat transfer process. The sled 108 can be provided at a bottom of the CDU 100 to receive any condensation and leaked fluid. In some examples, the sled 108 can include leak detection sensors that can provide information about presence of excessive moisture from condensation forming on surfaces of the coil bank 120 or any potential coolant leaks in the CDU 100.

In some cases, having two or more coils (e.g., heat exchangers) in a coil bank can increase a heat transfer capacity of a CDU over applications including only a single heat exchanger (e.g., a single coil). As shown, the first heat exchanger 122 and the second heat exchanger 124 of the coil bank 120 can be arranged within the CDU to increase a surface area over which a heat transfer occurs in the CDU 100. Each of the first heat exchanger 122 and the second heat exchanger 124 can define a respective surface area (e.g., projected surface area) through which air can pass through, and the combined surface area of the first and second heat exchanger 122, 124 can be greater than a surface area of a single heat exchanger configured to occupy the same space.

For example, a width W1 of the first heat exchanger 122 can correspond to a surface area of the first heat exchanger 122, and a width W2 of the second heat exchanger 124 can correspond to a surface area of the second heat exchangers 124. The width W1 and the width W2 can each be measured in a direction between a first lateral side wall 302 of the housing 106 and a second lateral side wall 304 of the housing 106. In some examples, a surface area of a heat exchanger can positively correlate to a surface area of liquid coils of the heat exchanger over which an air can flow to transfer heat from fluid within the coils (e.g., via convection, etc.). Generally, more air can flow through an increased (e.g., larger) surface area, increasing an amount of heat transfer through a heat exchanger. Accordingly, the increased surface area can provide an increased heat transfer capacity of the coil bank 120 and allow the CDU 100 to handle greater thermal loads.

In the illustrated example, the surface areas available for heat transfer through the first heat exchanger 122 and the second heat exchanger 124 are perpendicular to an intended direction of air flow, defined by respective widths and heights of the first heat exchanger 122 and the second heat exchanger 124. As further shown, the first heat exchanger 122 and the second heat exchanger 124 are staggered longitudinally (e.g., along an elongate direction of the CDU 100), in a direction parallel to an airflow. In the illustrated example, the first heat exchanger 122 is proximate the first lateral side wall 302, and extends a portion of a distance 310 between the first lateral wall 302 and the second lateral side wall 304. The second heat exchanger 124 is proximate the second lateral side wall 304 and extends a portion of the distance 310. In the example shown, the width W1 of the first heat exchanger 122 and the width W2 of the second heat exchanger 124 are the same (e.g., a width that is two-thirds a total width defined between the first lateral sidewall 304 and the second lateral sidewall 302). A combined width of heat exchangers of a coil bank (e.g., the first heat exchanger 122 and the second heat exchanger 124) can be greater than a width between lateral side walls of the CDU housing the coil bank (e.g., the distance 310). In some cases, heat exchanger of a coil bank can include different widths, as can accommodate a spacing requirement within a given CDU or provide better flow characteristics or greater equality of pressure dop across the respective heat exchangers.

Respective heights of the first heat exchanger 122 and the second heat exchanger 124 may be approximately the same or slightly less than an overall height of the CDU 100 (e.g., or the housing 106 as measured between a top side of the housing 106 and a bottom side of the housing 106). In some examples, a height of the first heat exchanger 122 and a height of the heat exchanger 124 can be different. While in the illustrated example, the first heat exchanger 122 and the second heat exchanger 124 are positioned transverse (e.g., perpendicular) to a direction of air flow, in other examples, heat exchangers of a coil bank can be canted or positioned at an oblique angle relative to an air flow direction, as can further increase a surface area for heat transfer across the heat exchangers.

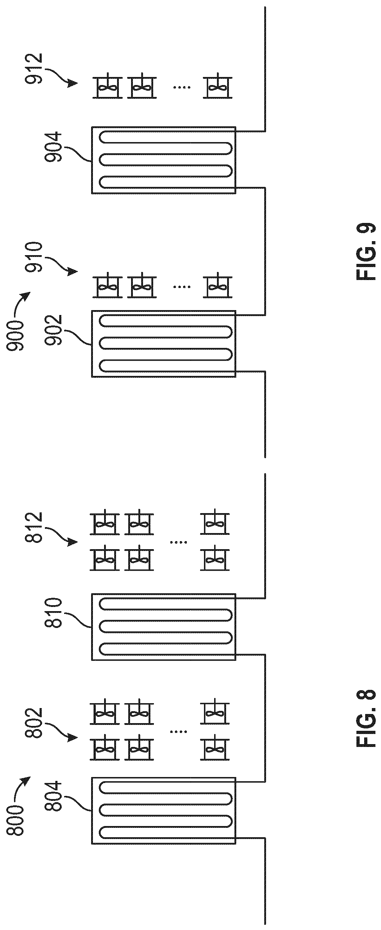

A flow of fluid and air through heat exchangers of a coil bank can be arranged to achieve desired heat transfer parameters with given constraints or flow characteristics. For example, as shown in FIG. 3, fluid can be distributed to the first heat exchanger 122 and the second heat exchanger 124 in parallel through branches 144a, 144b of the hot supply hose 144, respectively. For example, a flow through the hot supply hose 144 can be divided (e.g., at a T-fitting, a Y-fitting, a three-way valve, etc.) and a portion of the heated fluid can flow through branch 144a to heat exchanger 122, and another portion of the flow can flow through branch 144b to heat exchanger 124. In some cases, a flow rate through each of the first heat exchanger 122 and the second heat exchanger 124 can be controlled (e.g., via valves) to achieve a desired heat transfer rate for the CDU 100. For example, in some cases, a first heat exchanger (e.g., the first heat exchanger 122) defines a greater area for heat transfer than a second heat exchanger (e.g., the second heat exchanger 124), and a flow rate through the heat exchangers can be controlled to achieve a flow of fluid proportionate to the relative surface area of the respective heat exchangers. In some cases, different flow configurations can be defined for heat exchangers of a coil bank, as discussed further below with respect to FIGS. 8-11. In some cases, heat exchangers of a coil bank can provide redundancy and can increase a resiliency of a CDU against a single point of failure. For example, if the first heat exchanger 122 experiences a blockage, a leakage, or is otherwise removed from a fluid loop of the CDU 100, fluid can continue to flow through the second heat exchanger 124 to continue a cooling operation of the CDU 100. In some examples, when a reduction in a flow rate of fluid through the first heat exchanger 122 is detected, a flow rate of fluid through the second heat exchanger 124 can be increased to maintain an overall cooling capacity of the CDU 100.

In some cases, an air flow can be channeled to increase a heat transfer by directing air across heat exchangers of a coil bank of a CDU. For example, as shown in FIGS. 2-4, a baffle 132 can be provided to at least partially block an open area (e.g., a channel) between the first heat exchanger 122 and the second heat exchanger 124, to ensure (e.g., guide, direct, etc.) a flow of air across the first heat exchanger 122 and the second heat exchanger 124. The baffle 132 can be a rectangular sheet of material (e.g., metal, plastic, silicone, etc.). A side of the baffle 132 can be secured to a side of the first heat exchanger 122, and an opposite side of the baffle 132 can be secured to an adjacent side of the second heat exchanger 124. In some cases, additional air flow control elements can be provided for a CDU to achieve a desired distribution of air flow across heat exchangers of a coil bank. For example, baffles can be provided to direct air from fans of a CDU across particular heat exchangers to facilitate an even distribution of flow across the heat exchangers. In this regard, a baffle can be provided for CDU 100 that separates the air flow from the fans 113 of the left column and the fans 113 of the right column. The baffle can be positioned so that air flow from the fans 113 of the right column flows across heat exchanger 122, and air flow from the fans of the left column flow across heat exchanger 124. In some examples, geometries and positioning of elements (e.g., of fans and heat exchangers) can be arranged to achieve a symmetric pressure profile for heat exchangers of a coil bank as can advantageously produce a substantially equal air flow across the respective heat exchanger of a coil bank. While one baffle is provided in the present example, more baffles (e.g., two, three, four, five, etc.) can be provided to design particular air flow paths for particular implementations. In some examples, the additional air flow control elements can include a vane, a perforated plate, a flow straightener (e.g., a honeycomb flow straightener), etc.

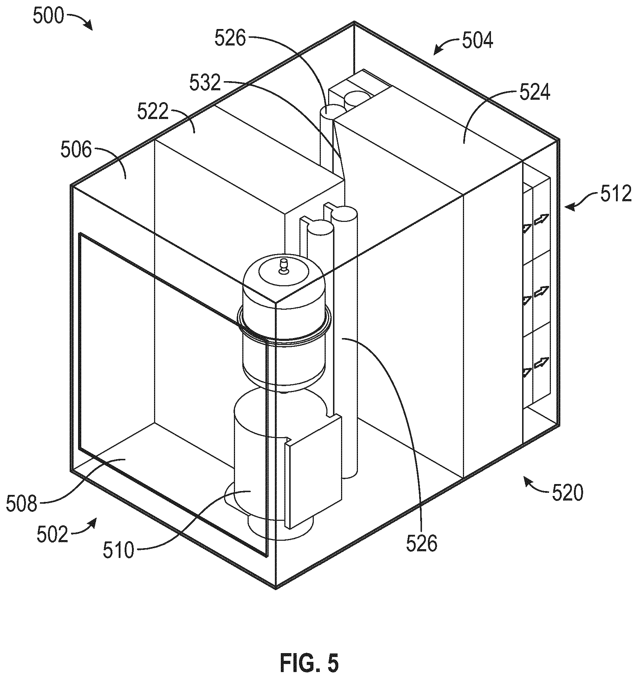

FIG. 5 illustrates another example of a CDU 500. As will be recognized, the CDU 500 shares a number of components in common with and operates in a similar fashion to the examples illustrated and described previously (e.g., the CDU 100). For the sake of brevity, these common features will not be again described below in detail. Rather, previous discussion of commonly named or numbered features, unless otherwise indicated, also applies to example configurations of the CDU 500.

A housing 506 can be provided to cover various components of the CDU 500 including the coil bank 520, a fan assembly 512, and a pump 510. One or more of the subassemblies can be supported on a tray 508. The coil bank 520 can include a first heat exchanger 522, a second heat exchanger 524, and a baffle 532 that bridges the first heat exchanger 522 and the second heat exchanger 524 at an angle. In some examples, the first heat exchanger 522 and the second heat exchanger 524 are arranged in series (e.g., with respect to a direction of fluid flow, with the first heat exchanger nearer a front end than the second heat exchanger). However, fluid flow through the first heat exchanger and the second heat exchanger may be parallel flow (e.g., fluid may pass through either the first heat exchanger or the second heat exchanger depending on a position of a valve). In other examples, the fluid may flow through both the first and second heat exchangers (e.g., in series-type flow), with fluid flowing through the first heat exchanger to the second heat exchanger. The first heat exchanger 522 and the second heat exchanger 524 include respective headers 526 that can be connected to a supply hosing to deliver liquid coolants through injectors. Further, the headers 526 can be connected to a return hosing to deliver liquid coolants that passed through coils (e.g., to transfer heat) to a return hosing.

Top and side walls of the housing 506 can permit retaining of airflow within the CDU 500 and limit undesirable leakage of air from the CDU 100. For example, as air flows through the first heat exchanger 522 or the second heat exchanger 524 from a front end 502 to a rear end 504 of the CDU 100, the housing walls may direct the air to remain within bounds of the housing 506. Correspondingly, airflow through the first heat exchanger 522 and the second heat exchanger 524 may be maximized. Further, the baffle 532 can permit an even distribution of airflow across the first heat exchanger 522 and the second heat exchanger 524 (e.g., by obstructing paths around the first heat exchanger 522 and the second heat exchanger 524/guiding fluid to the first and second heat exchanger).

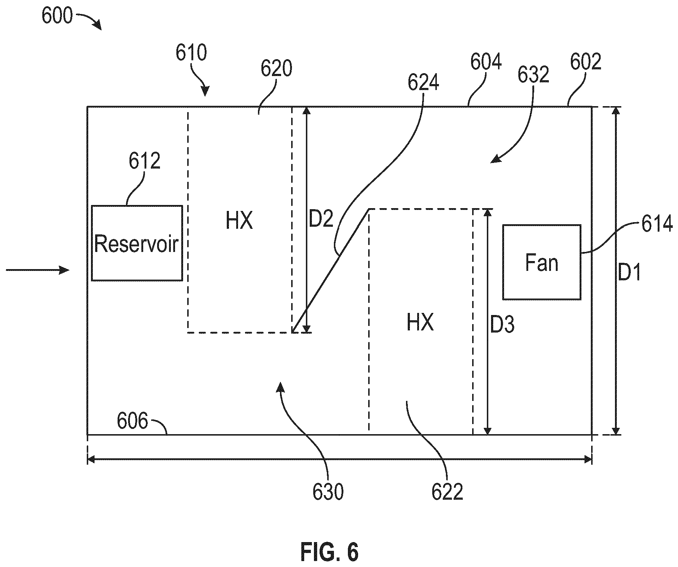

FIG. 6 illustrates another example of a CDU 600. As will be recognized, the CDU 600 shares a number of components in common with and operates in a similar fashion to the examples illustrated and described previously (e.g., the CDUs 100, 500). For the sake of brevity, these common features will not be again described below in detail. Rather, previous discussion of commonly named or numbered features, unless otherwise indicated, also applies to example configurations of the CDU 600.

In particular, a housing 602 of the CDU 600 can define a width D1 between a first lateral side wall 604 and a second lateral side wall 606. The housing 602 can be designed or configured to contain various components of the CDU 600. For example, the CDU 600 can include a coil bank 610, an area 612 for pump or reservoir that may be in fluid communication with the coil bank 610, and an area 614 for a fan assembly that can pull or push air flow through the coil bank 610. The coil bank 610 can include a first heat exchanger 620, a second heat exchanger 622, and a baffle 624 that may bridge the first heat exchanger 620 and the second heat exchanger 622 at an angle.

As shown, the first heat exchanger 620 defines a width D2 in a direction between the first lateral side wall 604 and the second lateral side wall 606. The second heat exchanger 622 defines a width D3 in a direction between the first lateral side wall 604 and the second lateral side wall 606. In the illustrated example, both of the width D2 and the width D3 are equal to .66*D1, and a combined width of the first heat exchanger 620 and the second heat exchanger 622 is therefore 1.33*D1. As noted above, widths of heat exchangers of a coil bank can be different, but a combined width of the heat exchangers can be greater than a width of the CDU (e.g., D2>D3 and D2 + D3 > D1). In some implementations, the heat exchangers may include different widths to achieve a desired cooling requirement. In some implementations, the heat exchangers may overlap one another to increase a total heat transfer surface area relative to a total heat transfer surface area available by a single heat exchanger. As shown, a gap 630 is defined between the first heat exchanger 620 and the second lateral side wall 606, as can allow an air flow to bypass the first heat exchanger 620 and flow to the second heat exchanger 622. Further, a gap 632 is defined between the second heat exchanger 622 and the first lateral side wall 604, as can allow an air flow to flow through the first heat exchanger 620 and bypass the second heat exchanger 622.

In some examples, the width D2 may be greater than 90% of the width D1, greater than 80% of the width D1, greater than 70% of the width D1, greater than 60% of the width D1, greater than 50% of the width D1, greater than 40% of the width D1, and so forth. The width D3 may be greater than 90% of the width D1, greater than 80% of the width D1, greater than 70% of the width D1, greater than 60% of the width D1, greater than 50% of the width D1, greater than 40% of the width D1, and so forth. In the present examples, a sum of the width D2 and the width D3 can be greater than the width D1. The width D2 and the width D3 are approximately the same in the present example, but the width D2 may be greater than the width D3, or the width D3 may be greater than the width D2.

Further, the width D2 and the width D3 may be determined to achieve a pressure profile that evenly distributes across the first heat exchanger 620 and the second heat exchanger 622. Further, by placing the first heat exchanger 620 and the second heat exchanger 622 parallel to each other (perpendicular to an air flow direction) and splitting the air flow into two segments, pressure of the air flow may drop at a smaller differential across the coil bank 610. While two heat exchangers are shown in the present example, fewer or more (e.g., three, four, five, etc.) heat exchangers can be arranged within the CDU 600. While one baffle is provided in the present example, more (e.g., two, three, four, five, etc.) baffles can be provided to configure air flow paths.

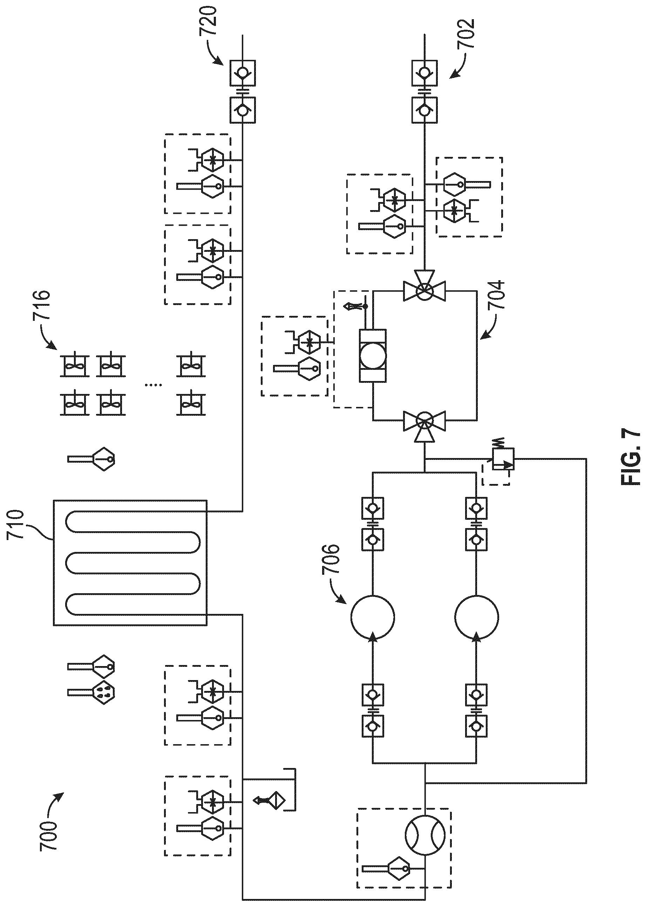

FIG. 7 illustrates a CDU 700 (e.g., similar to any of the CDUs 100, 500, 600 described above). As illustrated in FIG. 7, the CDU 700 includes a fluid supply 702 (e.g., to Information Technology (IT) infrastructure), a filter assembly 704, a pump assembly 706, a coil bank 710, a fan assembly 716, and a fluid return 720 (e.g., from IT infrastructure). The CDU 700 can include sensing components (e.g., temperature sensors, pressure sensors, flow rate sensors, fill lever sensors, etc.) along a flow path of air and fluid of the CDU 700. The sensors can be integrated with a control system of the CDU 700 and can be used, for example, to enact particular PID controllers. In particular, the CDU 700 includes temperature sensors and pressure sensors upstream of the fluid supply 702, upstream of the pump assembly 706, and downstream of the fluid return 720. A differential pressure sensor is provided at the filter assembly 704. A flow sensor and a temperature sensor are provided upstream of the pump assembly 706. A temperature sensor is provided both upstream and downstream of the coil bank 710, and a humidity sensor is further provided downstream of the coil bank 710. Accordingly, the CDU 700 can monitor or control various operational parameters of the flow path of air or fluid. In some examples, sensor data may be recorded over a period of time for trend analysis, predictive maintenance, or system optimization.

Additionally, specifications and sizes of various components of any of the CDUs 100, 500, 600, 700 can be optimized (e.g., to minimize air pressure differentials or liquid pressure differentials). For example, a number of heat exchanger coils and a height of a heat exchanger coil can be varied. The below table illustrates the results of various simulations of the performance of CDUs having coil banks of different specifications.

| Scenario | A | B | C | D | |
|---|---|---|---|---|---|
| No. of Coils in Coil Bank | 1 | 2 | 2 | 2 | |
| Dimension Height (in) | 30 | 15 | 15 | 21 | Per Coil |
| Dimension Length (in) | 30 | 30 | 30 | 30 | Per Coil |
| Standard air flow rate | 10000 | 10000 | 10000 | 10000 | Coil Bank |
| Entering air temperature (°F) | 50 | 50 | 50 | 50 | Coil Bank |
| Leaving air temperature (°F) | 76.9 | 76.9 | 76.9 | 79.8 | Coil Bank |
| GPM | 100 | 100 | 100 | 100 | Coil Bank |
| Entering fluid temperature (°F) | 100 | 100 | 100 | 100 | Coil Bank |
| Leaving fluid temperature (°F) | 94.5 | 94.5 | 94.5 | 93.5 | Coil Bank |
| Btu/hr | 293598 | 293598 | 293598 | 295133 | Coil Bank |
| Approach (°F) | 44.5 | 44.5 | 44.5 | 43.5 | Coil Bank |
| Air dP (in H2O) | 2.53 | 2.53 | 2.53 | 1.46 | Per Coil |
| Liquid dP (ft H2O) | 23.28 | 18.15 | 18.15 | 10.84 | Per Coil |
| Face Velocity (ft/min) | 1600 | 1600 | 1600 | 1143 | Per Coil |
| Tube Velocity (ft/second) | 10.7 | 10.7 | 10.7 | 7.7 | Per Coil |
| Rows | 3 | 3 | 3 | 3 | Per coil |
| Circuits | 5 | 5 | 5 | 10 | Per coil |

Coil banks can be provided for various flow arrangements of liquid and air. Continuing, FIGS. 8-11 illustrate CDUs with various arrangements of heat exchangers and fan assemblies. As shown in FIG. 8, in CDU 800, fans of the CDU 800 can be provided in series, and heat exchangers of a coil bank of the CDU 800 can be provided in series. In the configuration of FIG. 8, a first fan or set of fans 802 can direct a flow of air across a first heat exchanger 804 to cool a fluid flowing through the first heat exchanger 804. A fluid can flow out of the first heat exchanger 804 into a second heat exchanger 810, and a second fan or set of fans 812 can direct air flow across the second heat exchanger 810 to further cool the fluid. In this arrangement, substantially all of the fluid flow and substantially all of the air flow is directed across both of the first heat exchanger 804 and second heat exchanger 810. Further, the first set of fans 802 and the second set of fans 812 are each provided in one or more (e.g., multiple or a plurality of) rows.

FIG. 9 illustrates a CDU 900 including an alternate arrangement of fans and heat exchangers of a coil bank. As shown in FIG. 9, a first heat exchanger 902 and a second heat exchanger 904 can be provided in series (e.g., the second heat exchanger 904 can be downstream of the first heat exchanger 902). Further, a first set of fans 910 of the CDU 900 a second set of fans 912 of the CDU 900 can be provided in parallel in a single row. In this configuration, substantially all fluid flow traverses both the first heat exchanger 902 and the second heat exchanger 904, but an air flow is divided between the first heat exchanger 902 and the second heat exchanger 904 (e.g., air flowing across the first heat exchanger 902 does not flow across the second heat exchanger 904, and vice versa). Advantageously, a high mass flux of heat exchanger fluids can be provided when heat exchangers are arranged in series as shown the CDU 800 and the CDU 900. In some cases, an outlet air flow from an upstream heat exchanger may be an inlet air flow for a downstream heat exchanger. Thus, the upstream heat exchanger may exhibit a larger temperature difference through the upstream heat exchanger than the downstream heat exchanger.

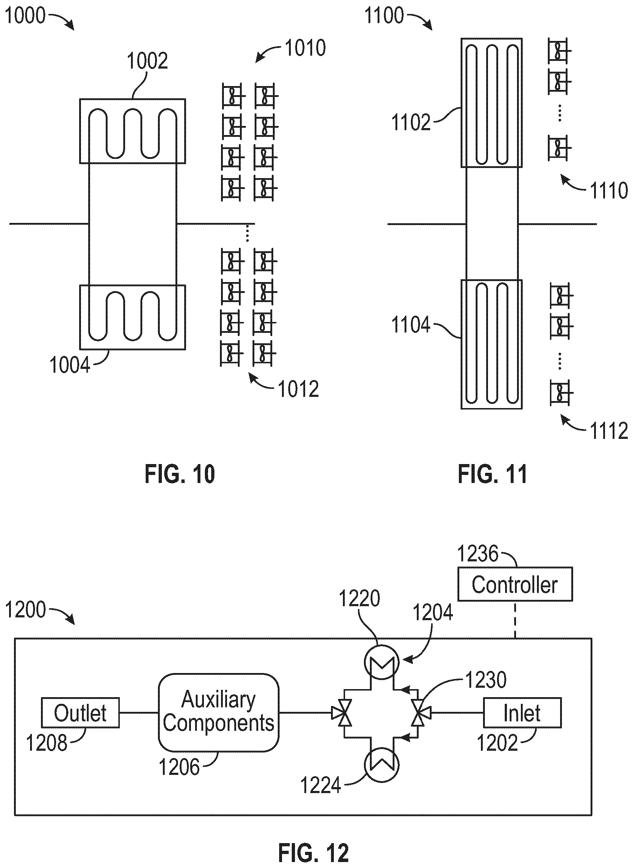

FIG. 10 illustrates a CDU 1000 with a first heat exchanger 1002 and a second heat exchanger 1004 of a coil bank arranged in parallel, with a plurality of fans arranged in series. In particular, a first set of fans 1010 and a second set of fans 1012 are arranged in one or more (e.g., multiple or a plurality of) rows. Thus, in the CDU 1000, a flow of air traverses both of the first heat exchanger 1002 and the second heat exchanger 1004, but fluid flows only through the first heat exchanger 1002 or the second heat exchanger 1004 (e.g., a portion of the fluid flow does not traverse both of the first heat exchanger 1002 and the second heat exchanger 1004).

FIG. 11 illustrates a CDU 1100 with a first heat exchanger 1102 and a second heat exchanger 1104 of a coil bank arranged in parallel and a first set of fans 1110 and a second set of fans 1112 arranged in parallel (e.g., similar to the configuration of the CDU 100 shown in FIGS. 1-4). Advantageously, temperature differentials across the two heat exchangers may be substantially the same. In some examples, the even temperature distribution can help to reduce or prevent thermal stress and provide consistent cooling performance across the CDU 1100.

Further, the parallel configuration of the fans (e.g., of the CDU 1100) and the coil bank (e.g., of the CDU 1000 or the CDU 1100) can provide redundancy, and the CDU 1000 or the CDU 1100 can continuously perform despite a failure or slow-down in one fluid path or one air flow path. In particular, parallel arrangements of multiple heat exchangers can enhance operational reliability by providing partial redundancy configurations. For example, when a first heat exchanger and a second heat exchanger are fluidly arranged in parallel, a CDU may continue to operate even when one heat exchanger experiences a failure, a leakage, reduced performance, etc. In some cases, CDUs can be designed or configured to provide partial redundancy to maintain cooling capacity at or above a threshold level when one heat exchanger operates at a reduced capacity. The parallel fluid arrangement can allow fluid to be redirected through the functioning heat exchanger (e.g., an optimal unit) while the other heat exchanger (e.g., non-functioning unit or a suboptimal unit) is isolated from the CDU system. In some examples, an increased amount of fluid can be directed through the functioning heat exchanger to compensate for the reduced cooling capacity of the non-functioning heat exchanger, thereby maintaining overall system performance within acceptable operational parameters. Accordingly, the CDU may maintain operational cooling capacity, for example, rather than experiencing downtime or complete system shutdown. Further, the partial redundancy of heat exchangers can provide a desired level of cooling capacity until replacement components can be installed or during maintenance periods.

FIG. 12 illustrates a CDU 1200 that includes a redundant heat exchangers. The CDU 1200 includes an inlet 1202, a coil bank 1204, auxiliary components 1206 (e.g., a fluid conditioning assembly), and an outlet 1208. A flow of fluid can enter the CDU 1200 through the inlet 1202 and flow into the coil bank 1204. As the fluid passes through the coil bank 1204, the fluid can be cooled (e.g., via a liquid-to-air heat exchange in a LTA system). Following this, the fluid can pass to the auxiliary components 1206 (e.g., pumps, filters, sensors, and other fluid conditioning elements that maintain fluid quality and circulation). The cooled fluid can then be returned to the IT equipment or continue through the cooling circuit via the outlet 1208. In some cases, the auxiliary components 1206 may be positioned upstream of the coil bank 1204, allowing the fluid to be conditioned before entering the coil bank 1204.

In one particular example, the coil bank 1204 includes a first heat exchanger 1220 and a second heat exchanger 1224 for cooling the fluid. In the illustrated example, the first heat exchanger 1220 and the second heat exchanger 1224 are arranged in a parallel configuration, similar to the first heat exchanger 1002 and the second heat exchanger 1004 of FIG. 10 or the first heat exchanger 1102 and the second heat exchanger 1104 of FIG. 11 as discussed above. In some examples, the first heat exchanger 1220 and the second heat exchanger 1224 can be arranged in a staggered configuration (e.g., as discussed above) to increase a total heat transfer surface area for cooling the fluid. In the parallel configuration, fluid can pass through both the first and second heat exchanger, the first heat exchanger only, or the second heat exchanger only depending on a position of a flow control valve 1230 upstream of the heat exchangers. Thus, the first and second heat exchangers may provide redundancy to the CDU, which may increase overall system performance and reduce downtime.

In the examples, the flow control valve 1230 can be positioned between the inlet 1202 and the coil bank 1204 to regulate fluid distribution between the first heat exchanger 1220 and the second heat exchanger 1224. The flow control valve 1230 can selectively direct fluid flow to one or both of the first heat exchanger 1220 and the second heat exchanger 1224 based on operational requirements, system conditions, or detected failures (e.g., of the heat exchangers, etc.). In some cases, the flow control valve 1230 may be a three-way valve that can modulate the flow split between the first heat exchanger 1220 and the second heat exchanger 1224, allowing for dynamic adjustment of cooling capacity distribution. In some examples, the flow control valve 1230 may be controlled by a controller 1236 (e.g., including a processor and a memory) that monitors system performance and can adjust flow distribution (e.g., to the first and second heat exchangers) to optimize cooling efficiency or respond to component failures.

For example, when one heat exchanger (e.g., the first heat exchanger) experiences reduced performance or failure, the flow control valve 1230 can the fluid outlet port directing fluid to the non-functioning heat exchanger (e.g., the first heat exchanger) and direct a larger flow rate of fluid (e.g., by increasing pump output) to the functioning heat exchanger (e.g., the second heat exchanger) to maintain overall system cooling capacity. Further, a fan speed associated with the functioning heat exchanger can be increased to compensate for the reduced cooling capacity from the non-functioning heat exchanger (e.g., to increase airflow over the heat exchanger).

In some examples, the controller 1236 can control operation of the flow control valve 1230 or the fan assembly based on leak detection capabilities integrated into the CDU 1200. In particular, the CDU 1200 can include leak detection cables near or along the first heat exchanger 1220 and the second heat exchanger 1224 (e.g., at connection points, manifolds, or along heat exchanger coils). The leak detection cables (or other sensors) can be in communication with the controller 1236 and provide information regarding the operational status of the first heat exchanger 1220 and the second heat exchanger 1224.

In some examples, the leak detection cables can detect the presence of leaked fluid in areas where mechanical failures, corrosion, or other damage to heat exchanger components may result in coolant leakage. In some examples, the leak detection cables can provide information about a location or a level of the leakage in the first heat exchanger 1220 or the second heat exchanger 1224. Accordingly, the flow of fluid (e.g., from the pump through the flow control valve 1230) or air (e.g., from the fans over the heat exchangers) can be adjusted to provide a desired level of cooling capacity, without stopping operation of the CDU 1200. For example, the performance of the coil bank 1204 can be increased by directing an increased flow rate of fluid through the functioning heat exchanger, resulting in performance that may be greater than having one working heat exchanger operating under normal conditions.

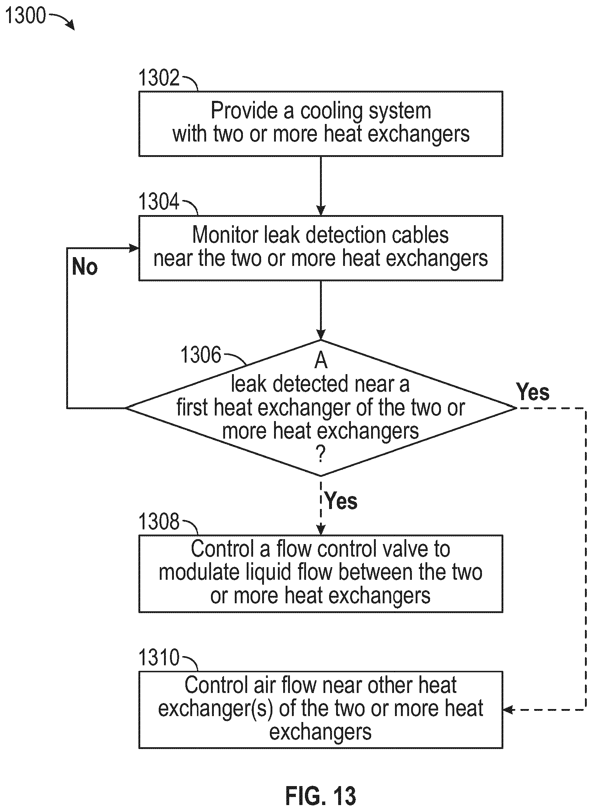

FIG. 13 illustrates a method 1300 of operating a redundant heat exchanger system with leak detection capabilities. The method 1300 may be implemented in cooling distribution units (e.g., the CDU 100, 1200, etc.) that include multiple heat exchangers arranged to provide cooling redundancy.

At stage 1302, a cooling system that includes two or more heat exchangers can be provided. The cooling system may include heat exchangers arranged in a parallel configuration, where fluid flow can be distributed between the heat exchangers to provide redundant cooling capability. In some examples, the system may include a flow control valve to control distribution of fluid flow between the heat exchangers. The cooling system may further include one or more sensors (e.g., leak detection cables) positioned near the heat exchangers to monitor for potential failures or fluid leakage at stage 1304. In some cases, the leak detection cables may be configured as continuity-based sensors that can detect the presence of leaked fluid and provide information about the location or level of leakage, mechanical failures, corrosion, or other damage to heat exchanger components that may result in fluid leakage.

At stage 1306, the controller monitoring the sensors determines whether a leak (or other issue) has occurred. For example, the sensor may indicate that a leak has been detected near the first heat exchanger. For example, the leak detection may be based on signals from the leak detection cables that indicate the presence of fluid outside the flow paths through the first heat exchanger. If a leak is not detected, then the method 1300 returns to stage 1304 and continues to monitor leak detection cables near the two or more heat exchangers. If a leak is detected, then the flow control valve can be controlled by the controller to modulate liquid flow between the two or more heat exchangers at stage 1308. In some cases, the flow control valve may close access to the non-functioning heat exchanger and direct a greater portion of the fluid flow to the functioning heat exchanger to maintain overall system cooling capacity.

Further, at stage 1310, air flow near the other heat exchanger of the two or more heat exchangers can be controlled. For example, to increase air flow, the fan speed may be increased, which may increase air flow over the functioning heat exchanger to compensate for the reduced cooling capacity from the non-functioning heat exchanger. In some cases, the air flow control may include adjusting the operation of multiple fan assemblies via the controller to optimize cooling performance across the remaining operational heat exchangers.

The following table presents three operational scenarios for heat exchanger redundancy analysis to demonstrate the performance characteristics of CDUs with partial redundancy configurations.

| | Coil Bank - Two coils with length x height = 10 in. x 20 in. each | | |
|---|---|---|---|
| Scenario | 1. Two coils working | 2. One coil fail- same liquid flow | 3. One coil fail - lower liquid flow |
| Air flow total (SCFM) | 2000 | 1500 | 1500 |
| Entering air temperature (°C) | 30 | 30 | 30 |
| Leaving air temperature (°C) | 45.3 | 47.8 | 46.7 |
| Liquid flow total (LPM) | 20 | **20** | **16.5** |
| Entering fluid temperature (°C) | 55 | 55 | 55 |
| Leaving fluid temperature (°C) | 42.2 | 43.8 | 42.2 |
| Heat load (kW) | 17.6 | 15.4 | 14.5 |
| Approaching temperature (°C) | 12.2 | 13.8 | 12.2 |
| Performance (%) | 100 | 88 | 82 |

The first scenario represents normal operation with both heat exchangers of a coil bank functioning under standard conditions, providing baseline performance metrics for comparison. The second scenario examines the case where one heat exchanger experiences failure, but the same total liquid flow rate is maintained by increasing flow through the remaining operational heat exchanger to compensate for the failed unit. The third scenario evaluates the situation where one heat exchanger fails, and the overall liquid flow is reduced relative to the second scenario, while maintaining the same approach temperature as the baseline two-coil operation. Some parameters were kept constant among all three scenarios, such as an outer diameter of a heat exchanger tube, a die pattern for heat exchangers, materials for heat exchanger tubes or fins, fin materials, fin types, fins per inch, number of rows of the tubes, etc.

As shown in the table above, the second and third scenarios demonstrate that, even with only one of the two heat exchangers in use, the system is still able to achieve greater than 75% performance. Thus, instead of having to render the system as non-operational during a heat exchanger failure, the redundant heat exchanger design permits the system to operate at about 75% performance. Further, this analysis demonstrates that increasing liquid flow through the remaining operational heat exchanger can provide cooling performance recovery, and the CDU can maintain operational cooling capacity (e.g., rather than experiencing complete system shutdown). The data indicates that partial redundancy configurations may achieve performance levels that exceed simple proportional reduction, providing enhanced system reliability during component failures.

In some implementations, devices or systems disclosed herein can be utilized, manufactured, installed, etc. using methods embodying aspects of the present disclosure. Correspondingly, any description herein of particular features, capabilities, or intended purposes of a device or system is generally intended to include disclosure of a method of using such devices for the intended purposes, of a method of otherwise implementing such capabilities, of a method of manufacturing relevant components of such a device or system (or the device or system as a whole), and of a method of installing disclosed (or otherwise known) components to support such purposes or capabilities. Similarly, unless otherwise indicated or limited, discussion herein of any method of manufacturing or using for a particular device or system, including installing the device or system, is intended to inherently include disclosure, as embodiments of the present disclosure, of the utilized features and implemented capabilities of such device or system.

### FURTHER EXAMPLES

Example 1. A cooling distribution unit, comprising: a housing defining a width between a first lateral side wall and a second lateral side wall; a coil bank disposed within the housing, the coil bank including: a first heat exchanger defining a first width; a second heat exchanger defining a second width, the second heat exchanger arranged fluidically in parallel with the first heat exchanger so that fluid flows to the first heat exchanger, the second heat exchanger, or both the first heat exchanger and the second heat exchanger; and a sum of the first width of the first heat exchanger and the second width of the second heat exchanger being greater than the width of the housing; and a fan assembly to direct airflow through the coil bank to cool a fluid passing through the first heat exchanger and the second heat exchanger.

Example 2. The cooling distribution unit of Example 1, wherein the first width of the first heat exchanger is greater than 60% of the width of the housing.

Example 3. The cooling distribution unit of Example 1 or 2, wherein the second width of the second heat exchanger is greater than 60% of the width of the housing.

Example 4. The cooling distribution unit of any one of Examples 1-3, further comprising: a baffle extending between the first heat exchanger and the second heat exchanger to direct air flow from the fan assembly through the first heat exchanger and the second heat exchanger.

Example 5. The cooling distribution unit of any one of Examples 1-4, wherein the first heat exchanger and the second heat exchanger are offset to form a first gap between the first heat exchanger and the second lateral side wall and a second gap between the second heat exchanger and the first lateral side wall.

Example 6. The cooling distribution unit of Example 5, wherein the first gap permits airflow from the fan assembly to bypass the first heat exchanger and flow to the second heat exchanger.

Example 7. The cooling distribution unit of Example 5 or 6, wherein the first heat exchanger and the second heat exchanger at least partially overlap in a direction parallel the direction of air flow from the fan assembly.

Example 8. A method of operating a cooling distribution unit having redundant heat exchangers, the method comprising: selectively directing fluid flow to a first heat exchanger, a second heat exchanger, or both the first heat exchanger and the second heat exchanger, the first heat exchanger and the second heat exchanger arranged in a fluidically parallel arrangement; monitoring the first heat exchanger and the second heat exchanger for fluid leakage using a leak detection system; detecting fluid leakage from the first heat exchanger; controlling a flow control valve to restrict fluid flow to the first heat exchanger in response to detecting the fluid leakage; and adjusting a fan speed of a fan assembly to increase airflow over the second heat exchanger to compensate for reduced cooling capacity from the first heat exchanger.

Example 9. The method of Example 8, wherein the leak detection system includes leak detection cables positioned near the first heat exchanger and the second heat exchanger.

Example 10. The method of Example 8 or 9, wherein controlling the flow control valve includes: closing a fluid access port to the first heat exchanger; and directing a greater flow rate of fluid to the second heat exchanger via increasing an operational speed of a pump.

Example 11. The method of Example 10, wherein the flow control valve is a three-way valve configured to selectively provide fluid flow to the first heat exchanger, the second heat exchanger, or both the first heat exchanger and the second heat exchanger.

Example 12. The method of any one of Examples 8-11, wherein the first heat exchanger is a microchannel heat exchanger.

Example 13. The method of any one of Examples 8-12, wherein the first heat exchanger and the second heat exchanger are arranged within a housing defining a width between a first lateral side wall and a second lateral side wall, and the first heat exchanger defines a first width that is greater than 60% of the width of the housing.

Example 14. The method of Example 13, wherein the second heat exchanger defines a second width, and wherein a sum of the first width of the first heat exchanger and the second width of the second heat exchanger being greater than the width of the housing.

Example 15. The method of any one of Examples 8-14, further comprising: directing air flow from the fan assembly through the first heat exchanger and the second heat exchanger via a baffle extending between the first heat exchanger and the second heat exchanger.

Example 16. A cooling distribution unit, comprising: a housing; a coil bank disposed within the housing, the coil bank including: a first heat exchanger; and a second heat exchanger arranged fluidically in parallel with the first heat exchanger; a flow control valve positioned upstream of the coil bank and configured to selectively direct fluid flow to the first heat exchanger, the second heat exchanger, or both the first heat exchanger and the second heat exchanger; a leak detection system to detect fluid leakage from the first heat exchanger or the second heat exchanger; and a controller to control the flow control valve based on signals from the leak detection system.

Example 17. The cooling distribution unit of Example 16, wherein the flow control valve is a three-way valve configured to selectively provide fluid flow to the first heat exchanger, the second heat exchanger, or both the first heat exchanger and the second heat exchanger.

Example 18. The cooling distribution unit of Example 16 or 17, further comprising: a fan assembly, the controller to increase an operational speed of the fan assembly when the leak detection system detects fluid leakage from the first heat exchanger or the second heat exchanger.

Example 19. The cooling distribution unit of Example 18, wherein the controller increases fan speed to compensate for reduced cooling capacity from a non-functioning heat exchanger.

Example 20. The cooling distribution unit of any one of Examples 16-19, wherein the controller closes a fluid access port from the flow control valve to a non-functioning heat exchanger and directs a greater flow rate of fluid to a functioning heat exchanger to maintain overall system cooling capacity when the leak detection system detects fluid leakage.

The previous description of the disclosed embodiments is provided to enable any person skilled in the art to make or use the present disclosure. Various modifications to these embodiments will be readily apparent to those skilled in the art, and the generic principles defined herein may be applied to other embodiments without departing from the spirit or scope of the present disclosure. Thus, the present disclosure is not intended to be limited to the embodiments shown herein but is to be accorded the widest scope consistent with the principles and novel features disclosed herein.

Features which are described in the context of separate embodiments may also be provided in combination in a single embodiment. Conversely, various features which are, for brevity, described in the context of a single embodiment, may also be provided separately or in any suitable sub-combination. The applicant hereby gives notice that new claims may be formulated to such features and/or combinations of such features during the prosecution of the present application or of any further application derived therefrom. Feature(s) of the cooling distribution unit described may be incorporated into/used in corresponding methods and vice versa.

As used herein, unless otherwise limited or defined, "or" indicates a non-exclusive list of components or operations that can be present in any variety of combinations, rather than an exclusive list of components that can be present only as alternatives to each other. For example, a list of "A, B, or C" indicates options of: A; B; C; A and B; A and C; B and C; and A, B, and C. Correspondingly, the term "or" as used herein is intended to indicate exclusive alternatives only when preceded by terms of exclusivity, such as "either," "one of," "only one of," or "exactly one of." For example, a list of "one of A, B, or C" indicates options of: A, but not B and C; B, but not A and C; and C, but not A and B. A list preceded by "one or more" (and variations thereon) and including "or" to separate listed elements indicates options of one or more of any or all of the listed elements. For example, the phrases "one or more of A, B, or C" and "at least one of A, B, or C" indicate options of: one or more A; one or more B; one or more C; one or more A and one or more B; one or more B and one or more C; one or more A and one or more C; and one or more of A, one or more of B, and one or more of C. Similarly, a list preceded by "a plurality of' (and variations thereon) and including "or" to separate listed elements indicates options of multiple instances of any or all of the listed elements. For example, the phrases "a plurality of A, B, or C" and "two or more of A, B, or C" indicate options of: A and B; B and C; A and C; and A, B, and C.

Certain operations of methods according to the present disclosure, or of systems executing those methods, may be represented schematically in the FIGS., or otherwise discussed herein. Unless otherwise specified or limited, representation in the FIGS. of particular operations in particular spatial order may not necessarily require those operations to be executed in a particular sequence corresponding to the particular spatial order. Correspondingly, certain operations represented in the FIGS., or otherwise disclosed herein, can be executed in different orders than are expressly illustrated or described, as appropriate for particular embodiments of the present disclosure. Further, in some embodiments, certain operations can be executed in parallel, including by dedicated parallel processing devices, or separate computing devices configured to interoperate as part of a large system.

Also as used herein, unless otherwise limited or defined, the terms "about," "substantially," and "approximately" refer to a range of values ± 5% of the numeric value that the term precedes. As a default the terms "about" and "approximately" are inclusive to the endpoints of the relevant range, but disclosure of ranges exclusive to the endpoints is also intended.

Also as used herein, unless otherwise limited or defined, "integral" and derivatives thereof (e.g., "integrally") describe elements that are manufacture as a single piece without fasteners, adhesive, or the like to secure separate components together. For example, an element stamped as a single-piece component from a single piece of sheet metal, without rivets, screws, or adhesive to hold separately formed pieces together is an integral (and integrally formed) element. In contrast, an element formed from multiple pieces that are separately formed initially then later connected together, is not an integral (or integrally formed) element.

Also as used herein, unless otherwise defined or limited, the term "lateral" refers to a direction that does not extend in parallel with a reference direction. A feature that extends in a lateral direction relative to a reference direction thus extends in a direction, at least a component of which is not parallel to the reference direction. In some cases, a lateral direction can be a radial or other perpendicular direction relative to a reference direction.

## Claims

1. A cooling distribution unit, comprising:
a housing defining a width between a first lateral side wall and a second lateral side wall;
a coil bank disposed within the housing, the coil bank including:
a first heat exchanger defining a first width;
a second heat exchanger defining a second width, the second heat exchanger arranged fluidically in parallel with the first heat exchanger so that fluid flows to the first heat exchanger, the second heat exchanger, or both the first heat exchanger and the second heat exchanger; and
a sum of the first width of the first heat exchanger and the second width of the second heat exchanger being greater than the width of the housing; and
a fan assembly to direct airflow through the coil bank to cool a fluid passing through the first heat exchanger and the second heat exchanger.

2. The cooling distribution unit of claim 1, wherein the first width of the first heat exchanger is greater than 60% of the width of the housing.

3. The cooling distribution unit of claim 1 or claim 2, wherein the second width of the second heat exchanger is greater than 60% of the width of the housing.

4. The cooling distribution unit of claim 1, claim 2 or lcaim 3, further comprising:
a baffle extending between the first heat exchanger and the second heat exchanger to direct air flow from the fan assembly through the first heat exchanger and the second heat exchanger.

5. The cooling distribution unit of claim 1 or of any of claims 2 to 4, wherein the first heat exchanger and the second heat exchanger are offset to form a first gap between the first heat exchanger and the second lateral side wall and a second gap between the second heat exchanger and the first lateral side wall.

6. The cooling distribution unit of claim 5, wherein the first gap permits airflow from the fan assembly to bypass the first heat exchanger and flow to the second heat exchanger.

7. The cooling distribution unit of claim 5 or claim 6, wherein the first heat exchanger and the second heat exchanger at least partially overlap in a direction parallel the direction of air flow from the fan assembly.

8. A method of operating a cooling distribution unit having redundant heat exchangers, the method comprising:
selectively directing fluid flow to a first heat exchanger, a second heat exchanger, or both the first heat exchanger and the second heat exchanger, the first heat exchanger and the second heat exchanger arranged in a fluidically parallel arrangement;
monitoring the first heat exchanger and the second heat exchanger for fluid leakage using a leak detection system;
detecting fluid leakage from the first heat exchanger;
controlling a flow control valve to restrict fluid flow to the first heat exchanger in response to detecting the fluid leakage; and
adjusting a fan speed of a fan assembly to increase airflow over the second heat exchanger to compensate for reduced cooling capacity from the first heat exchanger.

9. The method of claim 8, wherein the leak detection system includes leak detection cables positioned near the first heat exchanger and the second heat exchanger.

10. The method of claim 8 or claim 9, wherein controlling the flow control valve includes:
closing a fluid access port to the first heat exchanger; and
directing a greater flow rate of fluid to the second heat exchanger via increasing an operational speed of a pump.

11. The method of claim 10, wherein the flow control valve is a three-way valve configured to selectively provide fluid flow to the first heat exchanger, the second heat exchanger, or both the first heat exchanger and the second heat exchanger.

12. The method of claim 8 or of any of claims 9 to 11, wherein the first heat exchanger is a microchannel heat exchanger.

13. The method of claim 8 or of any of claims 9 to 12, wherein the first heat exchanger and the second heat exchanger are arranged within a housing defining a width between a first lateral side wall and a second lateral side wall, and the first heat exchanger defines a first width that is greater than 60% of the width of the housing.

14. The method of claim 13, wherein the second heat exchanger defines a second width, and wherein a sum of the first width of the first heat exchanger and the second width of the second heat exchanger being greater than the width of the housing.

15. The method of claim 8 or of any of claims 9 to 14, further comprising:
directing air flow from the fan assembly through the first heat exchanger and the second heat exchanger via a baffle extending between the first heat exchanger and the second heat exchanger.
